(19) **Europäisches Patentamt**
**European Patent Office**
**Office européen des brevets**

(11) Veröffentlichungsnummer : **0 095 060**
**B1**

(12) # EUROPÄISCHE PATENTSCHRIFT

(45) Veröffentlichungstag der Patentschrift :
22.10.86

(51) Int. Cl.⁴ : **H 03 K 5/01**

(21) Anmeldenummer : 83104320.3

(22) Anmeldetag : 02.05.83

(54) **Integrierter Impulsformer.**

(30) Priorität : 07.05.82 DE 3217264

(43) Veröffentlichungstag der Anmeldung :
30.11.83 Patentblatt 83/48

(45) Bekanntmachung des Hinweises auf die Patenterteilung : 22.10.86 Patentblatt 86/43

(84) Benannte Vertragsstaaten :
AT DE FR GB

(56) Entgegenhaltungen :
DE-A- 2 713 319
DE-A- 2 837 855
DE-A- 2 851 825
IEEE JOURNAL OF SOLID-STATE CIRCUITS, Band SC-15, Nr. 5, Oktober 1980, Seite 844

(73) Patentinhaber : Siemens Aktiengesellschaft Berlin und München
Wittelsbacherplatz 2
D-8000 München 2 (DE)

(72) Erfinder : Frieling, Focko, Dipl.-Ing.
Hohenschwangauplatz 32
D-8000 München 90 (DE)

## Beschreibung

Die Erfindung befaßt sich mit einem integrierten Impulsformer, der in MIS-Schaltungstechnik ausgeführt, an ein erstes Versorgungspotential sowie an ein zweites, als Bezugspotential dienendes Versorgungspotential angeschaltet und von einem Impulsgenerator mit Steuerimpulsen beaufschlagt ist. Unter dem Begriff « MIS-Schaltungstechnik » wird dabei eine Schaltungstechnik verstanden mit Elementen, die der Definition von « MIS-Struktur » auf Seite 130 in « Halbleiter-Elektronik », Band 2, Springer-Verlag Berlin-Heidelberg-New York 1973 entsprechen. Entsprechend werden nachstehend mit dem Begriff « MOS-Schaltkreise » Schaltkreise bezeichnet, deren Transistoren den auf Seite 136 der obengenannten Literatur definierten MOS-Transistoren entsprechen.

Solche Impulsformer werden häufig für dynamische MOS-Schaltkreise, insbesondere für RAM-Speicher mit Ein-Transistor-Speicherzellen, für die Betriebssteuerung benötigt. Das bei solchen Impulsformern angewendete Prinzip beruht darauf, daß im Impulsformer aufgrund der vom Oszillator gelieferten Primärimpulse die Entstehung von Sekundärimpulsen ausgelöst wird, die dann der weiteren Verwendung in der zu versorgenden Schaltung zugeführt werden. Die Entstehung der Sekundärimpulse geschieht nach Maßgabe eines durch den Aufbau der Schaltung für den Impulsformer bedingten Zeitrasters. Dabei ist in Anbetracht der mit MIS-Feldeffekttransistoren, insbesondere mit MOS-Feldeffekttransistoren, erreichbaren minimalen Schaltzeit bei den zur Verfügung stehenden Umformern immer nur ein festes Zeitraster möglich, von dem aus man durch Änderung von Transistorparametern (in erster Linie durch w/l-Änderungen) nur in ganz geringem Maße abweichen kann.

In Fällen, bei denen sich die realen Schaltungsverhältnisse (z. B. von Redesign-Maßnahmen) einer exakten Simulation entziehen (z. B. die Wortleitungsbelastung aufgrund von Änderungen von Chip-Abmessungen oder des Wortleitungsanstieges) ist ein bestehendes Zeitraster (Timing) praktisch nur über w/l-Änderungen an den in der Speicherschaltung bzw. sonstigen integrierten MOS-Schaltung ververwendeten MOS-Feldeffekttransistoren zu entschärfen, also abzuändern. Dieses Verfahren ist jedoch nur in eng begrenztem Umfang anwendbar, weil dadurch die Funktion des Umformers beeinträchtigt wird, weil außerdem dadurch eine Vergrößerung der Prozeßabhängigkeit sowie eine zeitlich große Änderung der Verzögerung zwischen dem einzelnen Steuerimpuls und dem durch ihn ausgelösten Sekundärimpuls oder gar ein vollständiges Ausbleiben verzögerter Impulse die Folge sein kann. Außerdem ist die angegebene Möglichkeit der Beeinflussung des Zeitrasters nicht anwendbar, wenn die Verzögerung der über den Umformer erhaltenen Sekundärimpulse gegenüber den auslösenden Primärimpulsen weniger als etwa 5 nsec betragen soll.

Eine an sich vorteilhafte Ausgestaltung für einen in MOS-Technik ausgeführten Impulsformer ist in « IEEE Journal of Solid-State Circuits » Vol. SC-15, No. 5, October 1980, auf Seite 844 beschrieben und im Schaltbild dargestellt. Jedoch ist auch dieser bekannte Impulsformer für sich allein nicht in der Lage, die Verzögerungen zwischen den einzelnen vom Impulsgeber gelieferten Primärimpulsen und den am Umformerausgang abgegebenen Sekundärimpulsen auf unterhalb von 5 nsec liegende Zeitspannen zu reduzieren.

Die Erfindung zielt nun darauf ab, aus einem von einem Impulsgenerator gelieferten Primärimpuls E einen Sekundärimpuls abzuleiten, dessen zeitliche Verzögerung relativ zum Erzeugerimpuls E nur durch die Schaltzeit eines einzigen Transistors bestimmt wird.

Um dieses Ziel zu erreichen ist gemäß der vorliegenden Erfindung vorgesehen, daß die vom Impulsgenerator (JG) gelieferten Steuerimpulse (E) sowohl zur unmittelbaren Beaufschlagung eines ersten Formerteiles (F1) als auch eines — zusätzlich über drei Signalausgänge (1, 2, 3) des ersten Formerteils (F1) gesteuerten und im Gegensatz zum ersten Formerteil (F1) nur an das erste Versorgungspotential ($V_{CC}$), aber nicht an das zweite Versorgungspotential ($V_{SS}$) angeschlossenen — zweiten Formerteils (F2) dienen, daß hierbei der erste Signalausgang (1) des ersten Formerteils (F1) zur Steuerung des Gates eines ersten Feldeffekttransistors (T1) vorgesehen ist, dessen Source-Drainstrecke einerseits mit dem die Steuerimpulse (E) liefernden Ausgang des Impulsgenerators (JG) und andererseits mit dem die zu erzeugenden Sekundärimpulse liefernden Signalausgang (A) im zweiten Formerteil (F2) unmittelbar verbunden und außerdem der zweite Signalausgang (2) des ersten Formerteils (F1) zur Steuerung des Gates eines zweiten Feldeffekttransistors (T2) vorgesehen ist, dessen Source-Drainstrecke zwischen dem Signalausgang (A) des zweiten Formerteils (F2) und dem einen Anschluß eines — mit seinem anderen Anschluß an den dritten Signalausgang (3) des ersten Formerteils (F1) angelegten — Kondensators (C1) liegt, daß hierbei der mit dem zweiten Feldeffekttransistor (T2) verbundene Anschluß des Kondensators (C1) über einen dritten Feldeffekttransistor (T3) mit dem ersten Versorgungspotential ($V_{CC}$) verbunden ist, daß das Gate des dritten Feldeffekttransistors (T3) entweder mit dem ersten Versorgungspotential ($V_{CC}$) verbunden ist oder mittels für die Steuerung des ersten Formerteils (F1) vorgesehener Vorladeimpulse (V) gesteuert ist, wobei diese Vorladeimpulse (V) in Pausen zwischen benachbarten Steuerimpulsen (E) auftreten,

— daß der erste Formerteil (F1) eine erste Einrichtung enthält, die infolge der ansteigenden Flanke jedes der vom Impulsgenerator (JG) gelieferten Steuerimpulse (E) am ersten Signalausgang (1) des ersten Formerteils (F1) ein erstes Signal (P1) erzeugt, das von einem Spannungswert ausgehend, der zwischen den beiden Versorgungspotentialen ($V_{SS}$, $V_{CC}$) liegt, gleichzeitig mit der ansteigenden Flanke des Steuerimpulses (E) seinen Spannungswert auf einen Spitzenwert erhöht, der jenseits des Wertes des ersten Versorgungspotentials ($V_{CC}$) liegt, und das sofort darauf auf den Wert des zweiten Versorgungspotentials ($V_{SS}$) absinkt,

— daß der erste Formerteil (F1) eine zweite Einrichtung enthält, die infolge der ansteigenden Flanke jedes der vom Impulsgenerator (JG) gelieferten Steuerimpulse (E) am zweiten Signalausgang (2) des ersten Formerteils (F1) ein zweites Signal (P2) erzeugt, das, von einem dem zweiten Versorgungspotential ($V_{SS}$) gleichen Spannungswert ausgehend, gleichzeitig mit der ansteigenden Flanke des Steuerimpulses (E) seinen Spannungswert auf den Wert des ersten Versorgungspotentials ($V_{CC}$) erhöht, das diesen nach Erreichen des Wertes des ersten Versorgungspotentials ($V_{CC}$) mit einer, gegenüber dem Erhöhen auf den Wert des ersten Versorgungspotentials ($V_{CC}$) vergrößerten Anstiegsgeschwindigkeit auf einen Wert erhöht, der jenseits des Wertes des ersten Versorgungspotentials ($V_{CC}$) liegt, und das diesen Spannungswert beibehält, auch über ein Auftreten der fallenden Flanke des Steuerimpulses (E) hinaus,

— daß der erste Formerteil (F1) eine dritte Einrichtung enthält, die infolge der ansteigenden Flanke jedes der vom Impulsgenerator (JG) gelieferten Steuerimpulse (E) am dritten Signalausgang (3) des ersten Formerteils (F1) ein drittes Signal (P3) erzeugt, das, von einem dem zweiten Versorgungspotential ($V_{SS}$) gleichen Spannungswert ausgehend, verzögert zur ansteigenden Flanke des Steuerimpulses (E) seinen Spannungswert auf den Wert des ersten Versorgungspotentials ($V_{CC}$) erhöht und diesen beibehält, auch über das Auftreten der fallenden Flanke des Steuerimpulses (E) hinaus,

— und daß schließlich Mittel vorgesehen sind, welche nach Ablauf der fallenden Flanke der vom Impulsgenerator (JG) gelieferten Steuerimpulse (E) und vor dem Ansetzen der steigenden Flane des nächsten Steuerimpulses (E) eine Rückkehr der an den drei Signalausgängen (1, 2, 3) des ersten Formerteils (F1) liegenden Signale (P1, P2, P3) in den unmittelbar vor dem Ansetzen des letzten Steuerimpulses (E) vorliegenden Zustand bewirken.

Im allgemeinen haben die in der Schaltung verwendeten MIS-Feldeffekttransistoren, insbesondere MOS-Feldeffekttransistoren denselben Leitungstyp ihres stromführenden Kanals. Bei den bevorzugten Ausgestaltungen sind außerdem nur selbstsperrende Feldeffekttransistoren verwendet.

Für den ersten Formerteil kann, wie noch anhand von Figur 5 näher dargestellt wird, mit Vorteil der in der genannten Literaturstelle « IEEE Journal of Solid-State Circuits » auf Seite 389 im Schaltbild dargestellte Impulsgenerator verwendet werden.

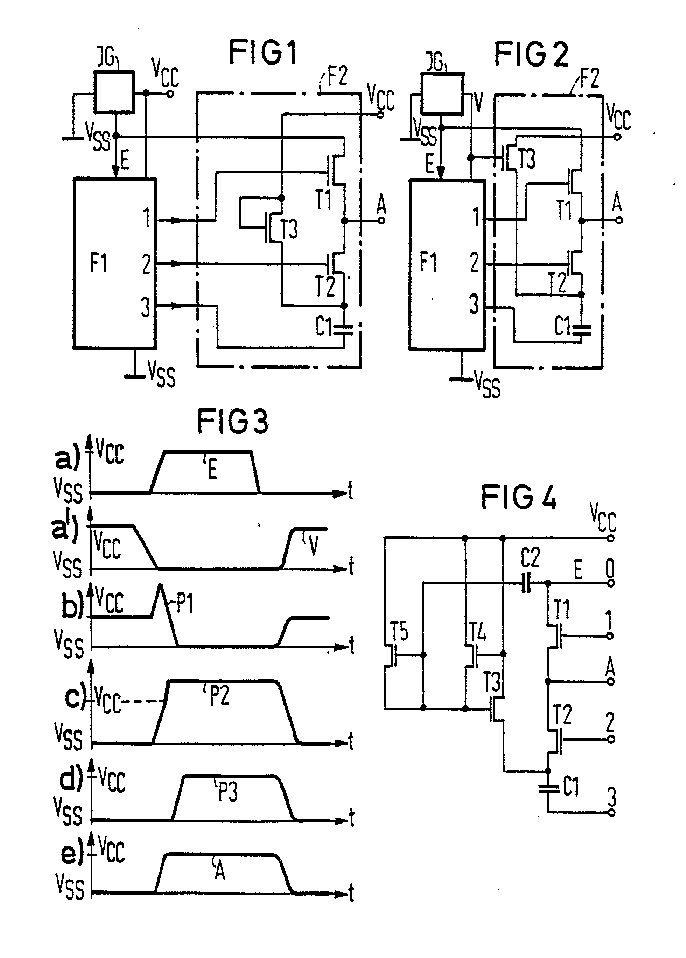

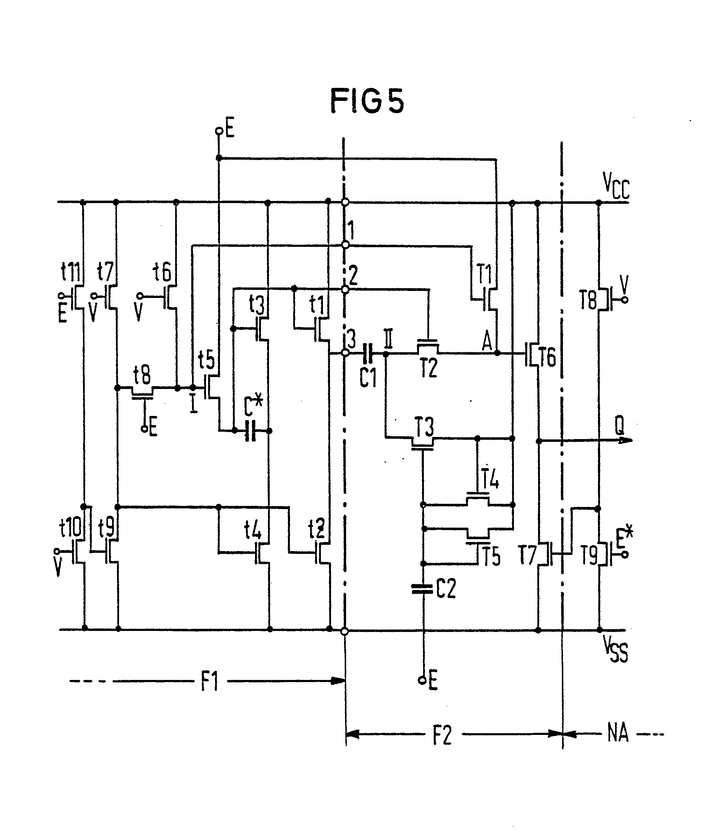

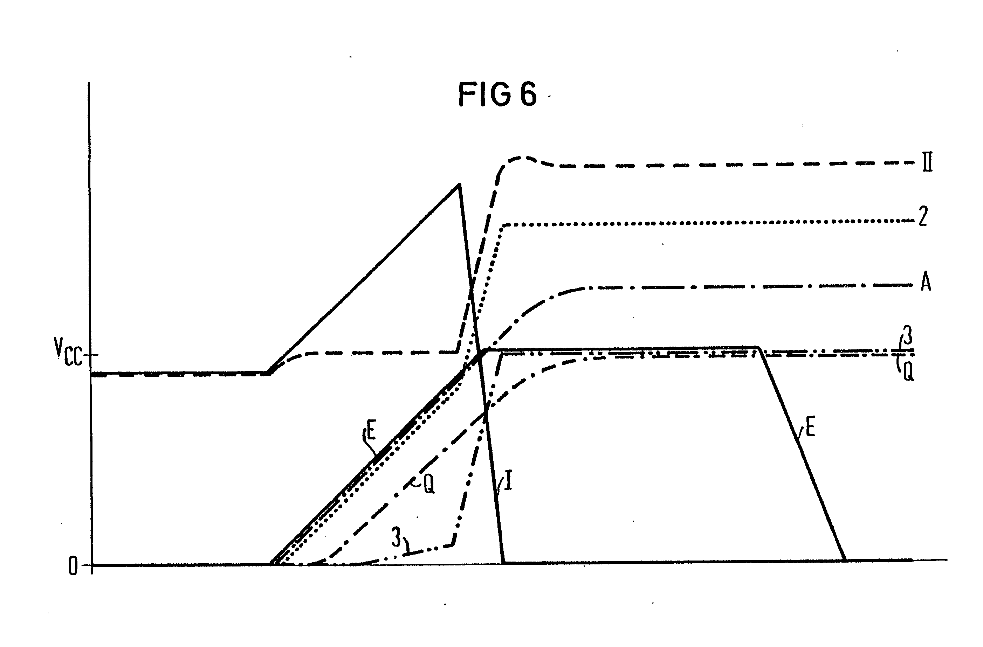

Die Erfindung sowie deren Wirkungsweise wird nun anhand der Figuren näher beschrieben. Dabei ist in Figur 1 und in Figur 2 die einfachste Ausgestaltung eines Impulsumformers gemäß der Erfindung und in Figur 3 das zugehörige Impulsdiagramm dargestellt. Figur 4 zeigt eine weitere Ausbildung für den zweiten Formerteil, während Figur 5 den noch weiter verbesserten zweiten Formerteil in Verbindung mit einer günstigen Ausgestaltung für den den ersten Formerteil bringt. In Figur 6 ist ein zu der Ausführung gemäß Figur 5 gehörendes Zeitdiagramm gebracht.

Die Erfindung wird nun zunächst anhand von Figur 1 vorgestellt. Entsprechend der Definition der Erfindung ist dort der die Primärimpulse, also die Steuerimpulse E liefernde Impulsgenerator IG sowohl zur Steuerung des ersten Formerteils F1 als auch des zweiten Formerteils F2 vorgesehen. Der erste Formerteil F1 hat einen ersten Signalausgang 1, der ein Signal P1 führt und der zur Steuerung des Gates des ersten Feldeffekttransistors T1 dient. Ein zweiter Signalausgang 2 dient zur Steuerung eines zweiten Feldeffekttransistors T2 und liefert ein Signal P2. Die beiden Feldeffekttransistoren T1 und T2 sowie die übrigen in der Schaltung gemäß Figur 1 verwendeten MOS-Feldeffekttransistoren, insbesondere auch der Feldeffekttransistor T3, sind sämtlich selbstsperrend und bevorzugt vom n-Kanaltyp. Allerdings ist auch eine Ausgestaltung sinnvoll, bei der die verwendeten MOS-Feldeffekttransistoren sämtlich vom p-Kanaltyp sind.

Die stromführenden Strecken des ersten Feldeffekttransistors T1 und des zweiten Feldeffekttransistors T2 liegen in Reihe zueinander, wobei der Signalausgang A des zweiten Formerteils F2 und damit der einfacheren Form des erfindungsgemäßen Impulsformers durch einen Knoten zwischen den beiden Transistoren T1 und T2 gegeben ist. Die Source des zweiten Transistors T2 ist mit dem ersten Anschluß eines Kondensators C1 unmittelbar verbunden und liegt außerdem an der Source des bereits genannten dritten Feldeffekttransistors T3. Der zweite Anschluß des genannten Kondensators C1 ist an den dritten Signalausgang 3 des ersten Formerteils F1 angeschlossen. Bei der in Figur 1 dargestellten einfachsten Ausführungsform der Erfindung ist das Gate des dritten Feldeffekttransistors T3 mit dem Drain dieses Transistors als auch mit dem ersten Versorgungspotential $V_{cc}$ unmittelbar verbunden. Hingegen ist — entsprechend der Definition der Erfindung — eine Verbindung zwischen einem Versorgungsanschluß des zweiten Formerteils F2 und dem — als Bezugspotential geschalteten — zweiten Versorgungspotential $V_{ss}$ nicht vorgesehen.

Die vom Impulsgenerator IG gelieferten Steuerimpulse E liegen sowohl an einem entsprechenden Steuereingang des ersten Formerteils F1 als auch an einem Steuereingang des zweiten Formerteils F2, der durch den Drainanschluß des ersten Transistors T1 im zweiten Formerteil F2 gegeben ist.

Bei der in Figur 1 dargestellten Ausführungsform der Erfindung ist somit der dritte Transistor T3 als Ladewiderstand für den Kondensator C1 geschaltet. Der Ladezustand dieses Kondensators C1 hängt einerseits vom Verhalten des ersten und des zweiten Feldeffekttransistors T1 und T2 als auch vom Signalzustand P3 am dritten Signalausgang 3 des ersten Formerteils F1 ab. Dasselbe gilt ersichtlich auch für den Signalzustand am Signalausgang A der in Figur 1 dargestellten Schaltung und damit für das vom Ausgang A abgegebene (und ebenfalls mit « A » bezeichnete) Sekundärsignal.

In Figur 3 ist das Zeitverhalten der Steuersignale W, der Potentiale P1, P2, P3 am ersten bzw. am zweiten bzw. am dritten Signalausgang des ersten Formerteils F1 sowie des Ausgangssignals A dargestellt. Ferner ist in Figur 3 das Zeitverhalten der bei der Ausgestaltung gemäß Figur 2 der Erfindung sowie bei einer Ausbildung des ersten Formerteils F1 gemäß Figur 5 benötigten und auch sonst beim Betrieb dynamischer Speicher üblicher Vorladeimpulse V gezeigt.

Mit der steigenden Flanke jedes der Steuerimpulse E wird neben dem aus Figur 3 ersichtlichen zeitlichen Verhalten an den Signalausgängen 1, 2 und 3 des ersten Formerteils F1 folgendes Verhalten der in Figur 1 dargestellten Schaltung ausgelöst. Zunächst ist der Kondensator C1 auf die Spannung $V_{cc} — U_T(T3)$ aufgeladen, wobei $U_T(T3)$ die Schwellspannung für den dritten Feldeffekttransistor T3 bedeutet. Der Transistor T3 ist vor Beginn der ansteigenden Flanke des Steuerimpulses E leitend, so daß der mit den Steuerimpulsen zu beaufschlagende Signaleingang des Formerteils F2 (also der Drain von T1) mit dem Signalausgang A von F2 verbunden ist. Der Spannungswert des Signals P1 hat das aus Fig. 3 ersichtliche und der Definition der Erfindung (Punkt a)) entsprechende zeitliche Verhalten. Da der Spannungswert von P1 aufgrund dieses zeitlichen Verhaltens zusammen mit der ansteigenden Flanke des Steuerimpulses E und dann über das erste Versorgungspotential $V_{cc}$ hinaus ansteigt, bleibt die leitende Verbindung zwischen dem von den Impulsen E gesteuerten Eingang und dem Signalausgang A des zweiten Formerteils erhalten. Der Spannungswert P2 am Gate des zweiten Feldeffekttransistors T2 führt zunächst nicht zu einem leitenden Zustand dieses Transistors, da dessen Sourcepotential während des Ansteigens des Steuerimpulses E konstant auf dem Wert $V_{cc} — U_T(T3)$ verbleibt. Erst wenn das Potential an der Signalausgangsklemme A den Wert des ersten Versorgungspotentials $V_{cc}$ erreicht hat (was durch das Zusammenwirken des Steuerimpulses E und dem Signal P1 am ersten Ausgang 1 des ersten Formerteils F1 erfolgt), wird die Spannung P1 am Ausgang 1 des ersten Formerteils F1 auf den Wert des zweiten Versorgungspotentials $V_{ss}$ umgeschaltet, so daß der Transistor T1 die Verbindung zwischen dem durch die Steuerimpulse E gesteuerten Eingang des zweiten Formerteils F2 und dem Signalausgang A sperrt. Gleichzeitig wird das Potential P2 am zweiten Signalausgang 2 des ersten Formerteils F1 und somit am Gate des zweiten Feldeffekttransistors T2 auf einen Wert oberhalb des ersten Versorgungspotentials $V_{cc}$ gebracht. Weiterhin wird über den Kondensator C1 aufgrund des vorgesehenen zeitlichen Verhaltens des am Signalausgang 3 des ersten Formerteils F1 abzugebenden Signals P3 auch das Potential am Sourceanschluß des zweiten Feldeffekttransistors T2 erhöht. Der zweite Transistor T2 wird also leitend, so daß nunmehr der Signalausgang A des zweiten Formerteils F2 auf einen oberhalb von $V_{cc}$-$V_{ss}$ liegenden Spannungswert — und zwar mit sehr großer Geschwindigkeit — überhöht werden kann.

Diese extrem rasche Erzeugung eines Sekundärimpulses mit im Vergleich zur Versorgungsspannung $(V_{cc}$-$V_{ss})$ überhöhtem Spannungswert ist der aufgrund einer Schaltung gemäß Figur 1 erzielte Vorteil. Wird nun das am Signalausgang A zur Verfügung gestellte Signal zur Steuerung eines weiteren MOS-Feldeffekttransistors, z. B. des Transistors T6 bei der Ausgestaltung gemäß Figur 5, verwendet, so ist die zeitliche Verzögerung des am Signalausgang dieses weiteren Transistors abgegebenen Signals Q gegenüber dem diesen Signalimpuls Q auslösenden Steuerimpuls E nur durch die Schaltzeit dieses weiteren Transistors T6 bestimmt.

Die in Figur 2 dargestellte Abänderung der in Figur 1 dargestellten Schaltung eines Impulsformers gemäß der Erfindung unterscheidet sich von der Schaltung gemäß Figur 1 darin, daß der dritte Feldeffekttransistor T3 (im Gegensatz zum ersten Transistor T1 und zum zweiten Transistor T2) vom selbstleitenden Typ ist und an seinem Gate durch die bereits eingeführten und bezüglich ihres zeitlichen Verlaufs ebenfalls in Figur 3 dargestellten Vorladeimpulse V (und nicht wie in Figur 1 durch das erste Versorgungspotential $V_{cc}$) gesteuert ist. Diese Vorladeimpulse V, die ausschließlich auf die Impulspausen zwischen den vom Impulsgeber IG gelieferten Steuerimpulse E beschränkt sind, werden in üblicher Weise erzeugt. Geeignete Impulsgeneratoren dieser Art sind z. B. in der DE-OS 27 13 319 beschrieben.

Die aus Figur 2 ersichtliche Abänderung gegenüber einer Schaltung gemäß Figur 1 hat den Effekt, daß der Startwert an der Source des zweiten Transistors T2 gleich dem ersten Versorgungspotential $V_{cc}$ ist, wodurch Spannungsverluste am Ausgang A des zweiten Formerteils F2 beim Übergang des zweiten Transistors T2 aus dem nichtleitenden in den leitenden Zustand (d. h. also im Augenblick der Verbindung des Signalausgangs A mit dem Sourceanschluß des zweiten Feldeffekttransistors T2 und damit mit dem Kondensator C1, deren Potential noch auf dem Wert $V_{cc} — U_T(T2)$ liegt) vermieden werden. Dadurch kann eine noch höhere Signalspannung am Ausgang A des zweiten Formerteils als bei einer Ausbildung gemäß Figur 1 erreicht werden.

Da der dritte Feldeffekttransistor T3 bei dieser Ausbildung vom selbstleitenden Typ ist, muß seine Gatespannung während des Ansteigens der Spannung an seinem Sourceanschluß erniedrigt werden, damit nicht ein Teil der Überhöhungswirkung durch Verbindung mit dem ersten Versorgungspotential unterdrückt wird.

Die in Figur 4 dargestellte Ausführungsform eines Impulsformers gemäß der Erfindung ist gegenüber der Ausführungsform gemäß Figur 1 weiter ausgestaltet und verbessert. Vor allem sind bei dieser weiteren Ausgestaltung zwei weitere MOS-Feldeffekttransistoren T4 und T5 vom Typ der Transistoren T1, T2 und T3 sowie ein zweiter Kondensator C2 vorgesehen. Die beiden zusätzlichen Transistoren T4 und T5 liegen mit ihrem Drain am ersten Versorgungspotential $V_{cc}$ und mit ihrer Source am Gate des dritten Feldeffekttransistors T3. Ferner ist das Gate des vierten Transistors T4 mit dem ersten Versorgungspotential $V_{cc}$ und das Gate des fünften Transistors T5 einerseits ebenfalls mit dem Gate des dritten Feldeffekttransistors T3 und andererseits über den Kondensator C2 mit dem Drain des ersten Feldeffekttransistors T1 verbunden und wird deshalb auch unmittelbar von dem vom Impulsgenerator IG gelieferten Steuerimpuls E gesteuert.

Gegenüber einer Schaltung gemäß Figur 1 und Figur 2 wird durch diese weitere Ausgestaltung gemäß Figur 4 erreicht, daß das Potential am Sourceanschluß des zweiten Transistors T2 vor dem Beginn des Ansteigens des einzelnen Steuerimpulses E auf den Wert des ersten Versorgungspotentials $V_{cc}$ angehoben wird, so daß also die Wirkung der Gesamtschaltung der Schaltung gemäß Fig. 2 entspricht. Die dort vorgesehene Ausgestaltung des dritten Feldeffekttransistors T3 als selbstleitender Feldeffekttransistor sowie die Steuerung dieses Transistors T3 durch die Vorladeimpulse V wird durch die Ausgestaltung des zweiten Formerteils F2 entsprechend Figur 4 in ihrer Wirkung durch die Wirkung der beiden zusätzlichen Feldeffekttransistoren T4 und T5 ersetzt. Man hat also die Alternative, entweder ausschließlich mit Feldeffekttransistoren vom selbstsperrenden Typ und dem Mehraufwand zweier zusätzlicher Transistoren oder mit einer von der Ausgestaltung der übrigen Transistoren T1 und T2 abweichenden Ausgestaltung für den dritten Transistor T3 die oben angegebene Verbesserung hinsichtlich der erhöhten Signalspannung am Ausgang A zu erreichen.

Die in Figur 5 dargestellte Ausführungsform eines Impulsformers gemäß der vorliegenden Erfindung zeigt die Kombination eines entsprechend Figur 4 ausgebildeten und ausgangsseitig durch den bereits erwähnten Transistor T6 ergänzten zweiten Formerteils F2 mit einer vorzugsweise anzuwendenden Ausgestaltung für den ersten Formerteil F1.

Die Ergänzung des zweiten Formerteils F2 durch eine Nachschaltung NA, wie sie in Figur 5 dargestellt ist, und die zusätzlich zu dem für die Ergänzung des zweiten Formerteils F2 vorgesehenen sechsten Feldeffekttransistor T6 und einem weiteren Transistor T7 vorgesehen ist, dient zur Steuerung des Sourcepotentials für den die vorzugsweise anzuwendenden Ausgangssignal Q liefernden sechsten Transistors T6. Neben dem Ausgangssignal Q können aber auch die am Ausgang A des zweiten Formerteils F2 anfallenden Impulse A, wie bereits oben angegeben, mit Vorteil verwendet werden.

Der an seinem Gate durch den Ausgang A einer Schaltung gemäß Figur 4 (oder auch gemäß Figur 2) gesteuerte sechste Feldeffekttransistor T6 liegt mit seinem Drain am ersten Versorgungspotential $V_{cc}$ und mit seiner Source unter Vermittlung der Source-Drainstrecke des genannten siebenten Feldeffekttransistors T7 am zweiten Versorgungspotential $V_{ss}$. Außerdem sind an dem zwischen der Source von T6 und dem Drain von T7 liegenden Signalausgang Q des weiter ergänzten zweiten Formerteils F2 die mit extrem geringer Verzögerung gegenüber den zugehörigen Steuerimpulsen E anfallenden Sekundärimpulse abnehmbar.

Das Gate des siebenten Feldeffekttransistors T7 wird durch einen Knoten gesteuert, der sich zwischen den beiden, die Nachschaltung NA bildenden Feldeffekttransistoren T8 und T9 befindet. Der eine dieser beiden in Reihe geschalteten Transistoren der Nachschaltung NA, nämlich der Transistor T8, liegt mit seinem Drain am ersten Versorgungspotential $V_{cc}$ und ist an seinem Gate durch die bereits wiederholt genannten Vorladeimpulse V gesteuert. Der zweite Transistor T9 in der Nachschaltung NA liegt mit seiner Source am zweiten Versorgungspotential $V_{ss}$ und ist an seinem Gate durch Impulse E* gesteuert. Diese Impulse E* setzen zeitlich etwas früher als die Impulse E ein und bleiben während deren jeweiliger Dauer erhalten. Beispielsweise lassen sich die Impulse E* durch einen Inverter erzeugen, dessen Eingang durch die Vorladeimpulse V gesteuert ist, sofern die Vorladeimpulse V und die jeweils unmittelbar vorausgehenden und nachfolgenden Steuerimpulse E jeweils durch eine spannungslose Phase von einander getrennt sind.

Zu erwähnen ist dabei, daß die im Formerteil F2 gemäß Figur 5 verwendeten Transistoren T1 bis T9 vomselben Kanaltyp und bevorzugt alle als selbstsperrende Feldeffekttransistoren, also als Feldeffekttransistoren vom Anreicherungstyp, ausgebildet sind.

Durch die aus Figur 5 ersichtlichen Ergänzungen des zweiten Formerteils F2 wird erreicht, daß an dem die Ausgangssignale Q liefernden Signalausgang nach der ansteigenden Flanke der einzelnen Steuerimpulse E ein ansteigender Potentialverlauf erscheint, der im wesentlichen nur durch die Wirkung des sechsten Feldeffekttransistors T6 verzögert ist, und der auch nach dem erneuten Abschalten des einzelnen Steuerimpulses E erhalten bleibt. Durch den Vorladeimpuls V wird sowohl im ersten Formerteil F1 als auch im zweiten Formerteil F2 als auch in der Nachschaltung NA der Ursprungszustand wieder hergestellt. Damit jedoch das schnelle Ansteigen an dem die Sekundärimpulse Q liefernden Ausgang des erweiterten Formerteils F2 nicht durch die hohe Gatespannung, die durch die Vorladung erzeugt wurde, behindert wird, indem der Transistor T7 länger im leitenden Zustand verbleibt, kann im Interesse der Ausnutzung der minimalen Verzögerung zwischen dem Steuerimpuls E und dem zugehörigen Sekundärimpuls Q das Gate des siebenten Transistors T7 durch ein verfrühtes Abschalten der Spannung am Knoten zwischen T8 und T9 durch einen bereits vor der ansteigenden Flanke von E erscheinenden Impuls E* am Gate von T9 gesperrt werden, so daß nun die Verzögerung zwischen den einzelnen Steuerimpulsen E und den durch sie jeweils mittels der Umformerschaltung erzeugten Sekundärimpulsen Q allein durch den sechsten Feldeffekttransistor T6 im zweiten Formerteil F2 bestimmt wird.

Die Figur 5 enthält außerdem Details über eine Ausbildungsform für den ersten Formerteil F1, der wie bereits erwähnt, in seiner Schaltungsstruktur dem bekannten Impulsformer entsprechend der Literaturstelle « IEEE Journal of Solid-State Circuits » entspricht. Zu bemerken ist dabei, daß die bekannte Schaltung als Impulsgenerator und nicht als erster Formerteil F1 im Sinne der vorliegenden Erfindung aufgrund der Offenbarungen der genannten Literaturstelle eingesetzt wird. Außerdem ist hierzu noch festzustellen, daß der bekannte Impulsgenerator für die Erzeugung der Steuerimpulse E und auch der Vorladeimpulse V eingesetzt werden kann. Für die Erzeugung der Vorladeimpulse V und der Steuerimpulse E kann z. B. auch ein Taktgeber entsprechend der DE-OS 28 37 855 einem eine periodische Folge von Rechteckimpulsen liefernden Oszillator nachgeschaltet sein, an dessen einem Taktausgang die Steuerimpulse TM (= E) und an dessen zweitem Taktausgang die Vorladeimpulse TS (= V) abnehmbar und für die Schaltung gemäß Figur 5 verwendbar sind.

Der erste Formerteil F1 bei der Ausgestaltung gemäß Figur 5 besteht aus elf Feldeffekttransistoren t1 bis t11, der denselben Typ, wie die Transistoren T1-T9 vom zweiten Schaltungsteil aufweisen, also im allgemeinen selbstsperrend sind. Außerdem ist noch ein Kondensator C* vorgesehen. Der Ausgestaltung der Schaltung in MIS-Technik, d. h. vorwiegend in MOS-Technik, entspricht es, wenn auch die Kondensatoren C1, C2 und C* der Schaltung durch sog-MOS-Varaktoren (allgemeiner durch MIS-Varaktoren) realisiert und in die monolithisch integrierte Schaltung des Impulsformers mit aufgenommen sind.

Der dritte Signalausgang 3 des in Figur 5 dargestellten ersten Formerteils F1, der zur Beaufschlagung des Kondensators C1 im zweiten Formerteil F2 dient, liegt zwischen zwei in Reihe geschalteten Transistoren t1 und t2, wobei der erste Transistor t1 mit seinem Drain am ersten Versorgungspotential $V_{cc}$ und mit seinem Gate am zweiten Signalausgang 2 des ersten Formerteils F1, während der zweite Transistor t2 mit seiner Source an das zweite Versorgungspotential $V_{ss}$ angeschlossen ist. Die Steuerung des Gates des zweiten Transistors t2 erfolgt über den siebenten und den neunten Transistor t7 bzw. t9 in noch näher zu beschreibender Weise. Eine in der Anschaltung an die beiden Versorgungspotentiale den beiden erstgenannten Transistoren t1 und t2 entsprechende Serienschaltung zweier weiterer Transistoren t3 und t4 ist mit einem zwischen den beiden Transistoren t3 und t4 liegenden Schaltungspunkt an den einen Anschluß des Kondensators C* gelegt, dessen zweiter Anschluß sowohl mit dem Gate des am ersten Versorgungspotential $V_{cc}$ liegenden Transistors t3 als auch mit dem zweiten Signalausgang 2 und damit mit dem Gate des ersten Transistors t1 verbunden ist. Das Gate des am zweiten Versorgungspotential liegenden vierten Transistors t4 ist mit dem Gate des zweiten Transistors t2 unmittelbar verbunden und wird gemeinsam mit diesem mittels der Transistoren t7 und t9 gesteuert. Der zweite Anschluß des genannten Kondensators C* ist schließlich über die Source-Drainstrecke des fünften Feldeffekttransistors t5 mit dem die Steuerimpulse E liefernden Ausgang des Impulsgenerators verbunden.

Der zeitliche Verlauf des Potentials am zweiten Anschluß des Kondensators C und damit am zweiten Signalausgang 2 des ersten Formerteils F1 ist im Zeitdiagramm der Fig. 6 dargestellt. Außerdem enthält die Fig. 6 den Verlauf des Potentials II an dem dem dritten Signalausgang 3 abgewandten Anschluß des Kondensators C1 im zweiten Formerteil F2, den zeitlichen Verlauf der Ausgangssignale A bzw. Q sowie den Potentialverlauf I am Gate des fünften Transistors t5 im ersten Formerteil F1. Ersichtlich ist der Verlauf des Potentials II dem Verlauf des Potentials am dritten Signalausgang 3 und der Verlauf des Potentials I dem Verlauf des Potentials am ersten Signalausgang 1 des ersten Formerteils gleich.

Wie aus Figur 5 weiter ersichtlich, liegt das Gate des fünften Transistors t5 im ersten Formerteil F1 sowohl am ersten Signalausgang 1 des ersten Formerteils als auch über die Source-Drainstrecke des sechsten Transistors t6 am ersten Versorgungspotential $V_{cc}$ als auch über die Serienschaltung des siebenten und des achten Transistors, also der beiden Feldeffekttransistoren t7 und t8, ebenfalls am ersten Versorgungspotential $V_{cc}$. Andererseits stellt die Serienschaltung des achten Transistors t8 mit dem neunten Transistor t9 eine Verbindung zwischen dem Gate des fünften Transistors t5 und dem ersten Signalausgang 1 mit dem Bezugspotential $V_{ss}$ dar. Ein Schaltungspunkt zwischen dem durch die Vorladeimpulse V gesteuerten siebenten Transistor t7 und dem mittels des zehnten Transistors t10 und des elften Transistors t11 gesteuerten neunten Transistor t9 dient dazu, um das Steuerpotential für die Gates des zweiten Transistors t2 und des vierten Transistors t4 zur Verfügung zu stellen. Transistor t8 ist durch die Steuerimpulse E und der Transistor t6 durch V gesteuert. Schließlich bilden auch der zehnte und der elfte Transistor eine Reihenschaltung, bei der der Drain des an seinem Gate durch die Steuerimpulse E beaufschlagten elften Transistors t11 am ersten Versorgungspotential $V_{cc}$ und die Source des durch die Vorladeimpulse V gesteuerten zehnten Transistors t10 am zweiten Versorgungspotential $V_{ss}$ liegt. Damit ist die in Figur 5 dargestellte Schaltung vollständig beschrieben. Sie führt zur Ausbildung von Sekundärimpulsen mit einer schnellen positiven Flanke an dem Signalausgang A bzw. an dem die Impulse Q liefernden Ausgang des zweiten Formerteils.

Durch den einzelnen Vorladeimpuls V wird sowohl der Knoten zwischen dem siebenten Transistor t7 und dem neunten Transistor t9 liegende Knoten als auch der Knoten zwischen dem achten Transistor t8, dem sechsten Transistor t6 und fünften Transistor t5 und damit der erste Signalausgang 1 auf das Potential ($V_{cc}$ — $U_T$) vorgeladen ($U_T$ ist Schwellspannung von t6). Die Gates von t9 und t3 sowie der Knoten zwischen t3 und t4, der Knoten zwischen t1 und t2 sowie der Ausgang für das Sekundärsignal Q am zweiten Formerteil F2 befinden sich zunächst noch auf dem Wert des zweiten Versorgungspotentials $V_{ss}$. Der zwischen dem Kondensator C1 und den beiden Transistoren T2 und T3 liegende Knoten wird über diese beiden Transistoren auf das Potential ($V_{cc}$ — $2U_T$) aufgeladen, wobei $U_T$ der die Aufladung bewirkenden Transistoren (die für alle Transistoren der Einfachheit halber als gleich vorausgesetzt wird) bedeutet.

Der nach dem Erlöschen des Vorladeimpulses V auftretende Steuerimpuls E erzeugt zunächst eine « schnelle » Flanke am Ausgang Q, indem das Gate des sechsten Transistors T6 im zweiten Formerteil F2 über den Transfertransistor T1 hochgezogen wird. Die Gates der Transistoren T1 und t5 werden gemeinsam über die Kanalkapazitäten von T1 und t5 gebootstrapt. Damit geht auch das Potential am zweiten Signalausgang 2 des ersten Formerteils F1 hoch. Über den Transistor T6 wird der Ausgang Q direkt — und zwar verzögert um die Schaltzeit von T6, die durch die Dimensionierung dieses Transistors (w/l-Verhältnis) bestimmt ist — hochgezogen, während das Potential an den Gates von T1 und t5 und am dritten Signalausgang 3 des ersten Formerteils F1 auf einen Wert nahe dem Wert des Bezugspotentials $V_{ss}$ festgehalten wird.

Parallel hierzu wird der Wert des Potentials am Gate des Transistors T3 im zweiten Formerteil F2 auf den Maximalwert von ($U_{cc}$ + $U_T$) gebootstrapt. Als Folge hiervon wird der Wert des Potentials an dem mit dem zweiten Transistor T2 und dem dritten Transistor T3 im zweiten Formerteil F2 verbundene Anschluß des ersten Kondensators C1 im zweiten Formerteil F2 vorbereitenderweise unter Vermittlung des dritten Transistors T3 auf den Wert des ersten Versorgungspotentials $V_{cc}$ gezogen. Daraus resultiert eine günstigere Ausgangsposition für das Hochschieben des Potentials an dem zuletzt genannten Anschluß des ersten Kondensators C1. Da aufgrund der in Figur 5 dargestellten Schaltung das Potential P3 am dritten Signalausgang 3 des ersten Formerteils F1 und an dem zwischen dem ersten Transistor T1, dem zweiten Transistor T2 und dem Gate des sechsten Transistors T6 liegenden Knoten A bis zu diesem Zeitpunkt nur maximal den Wert des ersten Versorgungspotentials $V_{cc}$ erreicht haben kann und der zuletzt genannte Anschluß des ersten Kondensators C1 ebenfalls auf $V_{cc}$ liegt, bleibt der zweite Kondensator T2 im zweiten Schaltungsteil F2 gesperrt. Er öffnet erst, wenn der Knoten zwischen dem siebenten Transistor t7 und dem neunten Transistor t9 im ersten Formerteil F1 — bedingt durch die Verzögerung, die im ersten Schaltungsteil F1 durch den elften Transistor t11 bzw. durch den neunten Transistor t9 verursacht ist — auf den Wert des Bezugspotentials $V_{ss}$ geschaltet wird. Das Potential am Gate des zweiten Transistors T2 steigt dann über den Wert des ersten Versorgungspotentials $V_{cc}$, wodurch der nun leitend gewordene Transistor T2 das Gate des sechsten Transistors T6 mit dem ersten Kondensator C1 im zweiten Formerteil F2 verbindet. Da gleichzeitig das Potential an dem mit dem zweiten Transistor T2 und dem dritten Transistor T3 im zweiten Formerteil F2 verbundenen Anschluß des ersten Kondensators C1 gebootstrapt wird, kann ein überhöhter Level an das Gate des sechsten Transistors T6 über den Knoten A gelangen, wodurch das am Ausgang Q liegende Signalpotential den Wert des ersten Versorgungspotentials $V_{cc}$ annimmt.

Die aus dem achten Transistor T8 und dem neunten Transistor T9 bestehende Nachschaltung NA sorgt dafür, daß der Ausgang Q auch nach Abschaltung des Vorladeimpulses V dauernd auf dem Wert des Bezugspotentials $V_{ss}$ verbleibt. Um jedoch dann die schnelle positive Flanke des am Ausgang Q auftretenden Signals zu erhalten, muß dazu das Gate des siebenten Transistors T7 im zweiten Formerteil F2 über den neunten Transistor T9 im zweiten Formerteil F2 über den neunten Transistor T9 durch einen im Vergleich zum Steuerimpuls E etwas früheren Impuls E* gekillt werden. Wie bereits oben angedeutet, läßt sich der Impuls E* ohneweiteres mit Hilfe der einzelnen Vorladeimpulse V in bekannter Weise mittels eines Verzögerungsgliedes bzw. eines Inverters gewinnen.

Stattdessen kann man auch am Gate des siebenten Transistors T7 den Vorladeimpuls V anlegen, so daß die Transistoren T8 und T9 entfallen können.

Wie bereits angegeben, kann der Steuerimpuls von einem beliebigen, digitale Impulse liefernden Impulsgenerator stammen. Liefert ein solcher Generator gleichzeitig mehrere Sekundärimpulse, so kann jedem je eine Impulssorte liefernden Signalausgang des Generators JG je eine der Erfindung entsprechende Umformerschaltung zugeordnet werden.

## Patentansprüche

1. Integrierter Impulsformer, der in MIS-Schaltungstechnik ausgeführt, an ein erstes Ver-

sorgungspotential ($V_{CC}$) sowie an ein zweites, als Bezugspotential dienendes Versorgungspotential ($V_{SS}$) angeschaltet und von einem Impulsgenerator (JG) mit Steuerimpulsen (E) beaufschlagt ist, dadurch gekennzeichnet, daß die vom Impulsgenerator (JG) gelieferten Steuerimpulse (E) sowohl zur unmittelbaren Beaufschlagung eines ersten Formerteiles (F1) als auch eines — zusätzlich über drei Signalausgänge (1, 2, 3) des ersten Formerteils (F1) gesteuerten und im Gegensatz zum ersten Formerteil (F1) nur an das erste Versorgungspotential ($V_{CC}$), aber nicht an das zweite Versorgungspotential ($V_{SS}$) angeschlossenen — zweiten Formerteils (F2) dienen, daß hierbei der erste Signalausgang (1) des ersten Formerteils (F1) zur Steuerung des Gates eines ersten Feldeffekttransistors (T1) vorgesehen ist, dessen Source-Drainstrecke einerseits mit dem die Steuerimpulse (E) liefernden Ausgang des Impulsgenerators (JG) und andererseits mit dem die zu erzeugenden Sekundärimpulse liefernden Signalausgang (A) im zweiten Formerteil (F2) unmittelbar verbunden und außerdem der zweite Signalausgang (2) des ersten Formerteils (F1) zur Steuerung des Gates eines zweiten Feldeffekttransistors (T2) vorgesehen ist, dessen Source-Drainstrecke zwischen dem Signalausgang (A) des zweiten Formerteils (F2) und dem einen Anschluß eines — mit seinem anderen Anschluß an den dritten Signalausgang (3) des ersten Formerteils (F1) angelegten — Kondensators (C1) liegt, daß hierbei der mit dem zweiten Feldeffekttransistor (T2) verbundene Anschluß des Kondensators (C1) über einen dritten Feldeffekttransistor (T3) mit dem ersten Versorgungspotential ($V_{CC}$) verbunden ist, daß das Gate des dritten Feldeffekttransistors (T3) entweder mit dem ersten Versorgungspotential ($V_{CC}$) verbunden ist oder mittels für die Steuerung des ersten Formerteils (F1) vorgesehener Vorladeimpulse (V) gesteuert ist, wobei diese Vorladeimpulse (V) in Pausen zwischen benachbarten Steuerimpulsen (E) auftreten,

— daß der erste Formerteil (F1) eine erste Einrichtung enthält, die infolge der ansteigenden Flanke jedes der vom Impulsgenerator (JG) gelieferten Steuerimpulse (E) am ersten Signalausgang (1) des ersten Formerteils (F1) ein erstes Signal (P1) erzeugt, das von einem Spannungswert ausgehend, der zwischen den beiden Versorgungspotentialen ($V_{SS}$, $V_{CC}$) liegt, gleichzeitig mit der ansteigenden Flanke des Steuerimpulses (E) seinen Spannungswert auf einen Spitzenwert erhöht, der jenseits des Wertes des ersten Versorgungspotentials ($V_{CC}$) liegt, und das sofort darauf auf den Wert des zweiten Versorgungspotentials ($V_{SS}$) absinkt,

— daß der erste Formerteil (F1) eine zweite Einrichtung enthält, die infolge der ansteigenden Flanke jedes der vom Impulsgenerator (JG) gelieferten Steuerimpulse (E) am zweiten Signalausgang (2) des ersten Formerteils (F1) ein zweites Signal (P2) erzeugt, das, von einem dem zweiten Versorgungspotential ($V_{SS}$) gleichen Spannungswert ausgehend, gleichzeitig mit der ansteigenden Flanke des Steuerimpulses (E) seinen Spannungswert auf den Wert des ersten Versorgungspotentials ($V_{CC}$) erhöht, das diesen nach Erreichen des Wertes des ersten Versorgungspotentials ($V_{CC}$) mit einer, gegenüber dem Erhöhen auf den Wert des ersten Versorgungspotentials ($V_{CC}$) vergrößerten Anstiegsgeschwindigkeit auf einen Wert erhöht, der jenseits des Wertes des ersten Versorgungspotentials ($V_{CC}$) liegt, und das diesen Spannungswert beibehält, auch über ein Auftreten der fallenden Flanke des Steuerimpulses (E) hinaus,

— daß der erste Formerteil (F1) eine dritte Einrichtung enthält, die infolge der ansteigenden Flanke jedes der vom Impulsgenerator (JG) gelieferten Steuerimpulse (E) am dritten Signalausgang (3) des ersten Formerteils (F1) ein drittes Signal (P3) erzeugt, das, von einem dem zweiten Versorgungspotential ($V_{SS}$) gleichen Spannungswert ausgehend, verzögert zur ansteigenden Flanke des Steuerimpulses (E) seinen Spannungswert auf den Wert des ersten Versorgungspotentials ($V_{CC}$) erhöht und diesen beibehält, auch über das Auftreten der fallenden Flanke des Steuerimpulses (E) hinaus,

— und daß schließlich Mittel vorgesehen sind, welche nach Ablauf der fallenden Flanke der vom Impulsgenerator (JG) gelieferten Steuerimpulse (E) und vor dem Ansetzen der steigenden Flane des nächsten Steuerimpulses (E) eine Rückkehr der an den drei Signalausgängen (1, 2, 3) des ersten Formerteils (F1) liegenden Signale (P1, P2, P3) in den unmittelbar vor dem Ansetzen des letzten Steuerimpulses (E) vorliegenden Zustand bewirken.

2. Impulsformer nach Anspruch 1, dadurch gekennzeichnet, daß die drei Feldeffekttransistoren (T1, T2, T3) vom selbstsperrenden Typ mit gleicher Kanaldotierung sind und daß das Gate des dritten Feldeffekttransistors (T3) mittelbar oder unmittelbar mit dem ersten Versorgungspotential ($V_{CC}$) verbunden ist.

3. Impulsformer nach Anspruch 2, dadurch gekennzeichnet, daß das Gate des dritten Feldeffekttransistors (T3) unmittelbar an das erste Versorgungspotential ($V_{cc}$) gelegt ist.

4. Impulsformer nach Anspruch 1, dadurch gekennzeichnet, daß im Falle einer Steuerung des Gates des dritten Feldeffekttransistors (T3) durch in den Pausen zwischen den Steuerimpulsen (E) auftretenden Vorladeimpulsen (V) die Feldeffekttransistoren (T1, T2, T3) im zweiten Formerteil (F2) zwar übereinstimmende Kanaldotierung aufweisen, daß aber der dritten Feldeffekttransistor (T3) vom selbstleitenden Typ und die übrigen Transistoren (T1, T2) vom selbstsperrenden Typ sind.

5. Impulsformer nach Anspruch 2, dadurch gekennzeichnet, daß ein vierter Feldeffekttransistor (T4) und ein fünfter Feldeffekttransistor (T5) vom Typ der übrigen Feldeffekttransistoren (T1, T2, T3) sowie ein zweiter Kondensator (C2) im zweiten Formerteil (F2) vorgesehen und dabei das Gate des dritten Feldeffekttransistors (T3) über die zueinander parallel geschalteten Source-Drainstrecken des vierten und des fünften Feldeffekttransistors (T4, T5) an das erste Versorgungspotential (V$_{cc}$) gelegt und außerdem mit dem Gate des fünften Feldeffekttransistors (T5) sowie über den zweiten Kondensator (C2) mit dem die Steuerimpulse (E) liefernden Ausgang des Impulsgenerators (JG) verbunden ist, während das Gate des vierten Feldeffekttransistors (T4) am ersten Versorgungspotential (V$_{cc}$) liegt.

6. Impulsformer nach einem der Ansprüche 1 bis 5, dadurch gekennzeichnet, daß der erste Formerteil (F1) elf Feldeffekttransistoren (t1-t11) vom Typ des ersten Transistors (T1) im zweiten Formerteil (F2) und einen Kondensator (C*) enthält und neben den vom Impulsgenerator (JG) gelieferten Steuerimpulsen (E) durch die Vorladeimpulse (V) gesteuert ist.

7. Impulsformer nach Anspruch 6, dadurch gekennzeichnet, daß ein erster Feldeffekttransistor (t1) mit seinem Drain am ersten Versorgungspotential (V$_{cc}$) liegt und mit seiner Source den dritten Signalausgang (3) des ersten Formerteils (F1) bildet sowie über einen zweiten Feldeffekttransistor (t2) an das zweite Versorgungspotential (V$_{ss}$) gelegt ist, daß dabei das Gate des ersten Transistors (t1) einerseits mit dem zweiten Signalausgang (2) und andererseits mit dem Gate eines dritten Feldeffekttransistors (t3) sowie mit dem einen Anschluß eines Kondensators (C*) verbunden ist, dessen zweiter Anschluß am Sourceanschluß des — mit seinem Drain am ersten Versorgungspotential (V$_{cc}$) liegenden — dritten Transistors (t3) sowie über einen vierten Transistor (t4) am zweiten Versorgungspotential (V$_{ss}$) liegt, daß außerdem die Gates des zweiten Transistors (t2) und des vierten Transistors (t4) gemeinsam an einen Schaltungspunkt zwischen einem siebenten Transistor (t7) und einem neunten Transistor (t9) angeschlossen sind, wobei der am ersten Versorgungspotential (V$_{cc}$) liegende Transistor (t7) durch die Vorladeimpulse (V) gesteuert und außerdem mit seinem Sourceanschluß über einen — vom Impulsgenerator (JG) mittels der Steuerimpulse (E) gesteuerten — achten Feldeffekttransistor (t8) sowohl an den ersten Signalausgang (1), als auch an das Gate eines fünften Transistors (t5) als auch an die Source eines sechsten Transistors (t6) gelegt ist, daß hierbei der Sourceanschluß des fünften Feldeffekttransistors (t5) mit dem Gate des dritten Feldeffekttransistors (t3) und sein Drainanschluß an den die Steuerimpulse (E) liefernden Ausgang des Impulsgenerators (JG) gelegt ist, während der Drain des sechsten Transistors (t6) mit der Klemme für das erste Versorgungspotential (V$_{cc}$) verbunden und sein Gate durch die Vorladeimpulse (V) gesteuert ist, daß diese Vorladeimpulse (V) auch noch zur Steuerung des Gates eines zehnten Feldeffekttransistors (t10) dienen, der mit seinem Sourceanschluß am zweiten Versorgungspotential (V$_{ss}$) und mit seinem Drain sowohl am Gate des neunten Transistors (t9) als auch über die Source-Drainstrecke eines vom Steuerimpuls (E) gesteuerten elften Feldeffekttransistors (t11) am ersten Versorgungspotential (V$_{cc}$) angeschlossen ist, und daß der neunte Transistor (t9) ebenso wie der zweite Transistor (t2), der vierte Transistor (t4) und der zehnte Transistor (t10) an das zweite Versorgungspotential (V$_{ss}$) gelegt ist.

8. Impulsformer nach einem der Ansprüche 1 bis 7, dadurch gekennzeichnet, daß der Signalausgang (A) des zweiten Formerteils (F2) an das Gate eines sechsten Feldeffekttransistors (T6) vom Typ des ersten Transistors (T1) im zweiten Formerteil (F2) angeschlossen ist, daß dabei der Drain des sechsten Transistors (T6) am ersten Versorgungspotential (V$_{cc}$) liegt, während sein Sourceanschluß einerseits einen weiteren Signalausgang (Q) des zweiten Formerteils (F2) bildet und außerdem über die Source-Drainstrecke eines siebenten Feldeffekttransistors (T7) mit dem zweiten Versorgungspotential (V$_{ss}$) verbunden ist, und daß das Gate des siebenten Feldeffekttransistors (T7) entweder durch die genannten Vorladeimpulse (V) oder durch eine vom Steuerimpuls (E) und einem weiteren Impuls (E*) gesteuerte und aus einem achten und einem neunten Feldeffekttransistor (T8, T9) bestehende Nachschaltung (NA) gesteuert ist.

## Claims

1. An integrated pulse shaper designed in MIS-circuit technology, connected to a first supply potential (V$_{CC}$) and to a second supply potential (V$_{SS}$) which serves as reference potential, and is acted upon by control pulses (E) of a pulse generator (JG), characterised in that the control pulses (E) supplied by the pulse generator (JG) serve both to directly act upon a first shaper component (F1) and a second shaper component (F2), which is additionally controlled via three signal outputs (1, 2, 3) of the first shaper component (F1) and, in contrast to the first shaper component (F1), are connected only to the first supply potential (V$_{CC}$) but not to the second supply potential (V$_{SS}$), that the first signal output (1) of the first shaper component (F1) serves to control the gate of a first field-effect transistor (T1) whose source-drain path is directly connected between that output of the pulse generator (JG) which supplies the control pulses (E) and that signal output (A) in the second shaper component (F2) which supplies the secondary pulses which are to be produced, and in addition the second signal output (2) of the first shaper component (F1) controls the gate of a second field-effect transistor (T2) whose source-drain path is located between the signal output (A) of the second shaper component (F2) and the first terminal of a capacitor (C1) connected by its other terminal to the third signal output (3) of the first shaper component (F1), that that terminal of the capacitor (C1) connected to the second field-effect transistor (T2) is connected via a third-effect transistor (T3) to the first supply potential (V$_{CC}$), that the gate of the third field-effect transistor (T3) is connected either to the first supply

potential (V<sub>CC</sub>) or is controlled by means of pre-load pulses (V) which serve to control the first shaper component (F1), where these pre-load pulses (V) occur in pauses between adjacent control pulses (E),

— that the first shaper component (F1) contains a first device which responds to the rising flank of each of the control pulses (E) supplied by the pulse generator (JG) at the first signal output (1) for the first shaper component (F1) to produce a first signal (P1) which, commencing from a voltage level between that of the two supply potentials ($V_{SS}$, $V_{CC}$), increases its voltage simultaneously with the rising flank of the control pulse (E) to a peak level a above that of the first supply potential ($V_{CC}$) and which immediately thereafter falls to the level of the second supply potential ($V_{SS}$),

— that the first shaper component (F1) contains a second device which responds to the rising flank of each of the control pulses (E) supplied by the pulse generator (JG) at the second signal output (2) of the first shaper component (F1) to produce a second signal (P2) which, commencing from a voltage level equal to the second supply potential ($V_{SS}$), increases its voltage simultaneously with the rising flank of the control pulse (E) to the level of the first supply potential ($V_{CC}$), and when the level of the first supply potential ($V_{CC}$) has been reached, increases this level at an increased speed greater than the increase to the level of the first supply potential ($V_{CC}$), to reach a level above that of the first supply potential ($V_{CC}$), and retains this voltage beyond the occurrence of the falling flank of the control pulse (E),

— that the first shaper component (F1) contains a third device which responds to the rising flank of each of the control pulses (E) supplied by the pulse generator (JG) at the third signal output (3) of the first shaper component (F1) to produce a third signal which, commencing from a voltage level equal to the second supply potential ($V_{SS}$), increases its voltage level with a delay in relation to the rising flank of the control pulse (E) to the level of the first supply potential ($V_{CC}$) and maintains this level, even after the occurrence of the falling flank of the control pulse (E), and

— that finally means are provided which respond at the end of the falling flank of the control pulses (E) supplied by the pulse generator (JG), and before the start of the rising flank of the next control pulse (E), to cause the signals (P1, P2, P3), occurring at the three signal outputs (1, 2, 3) of the first shaper component (F1), to return to the state which prevailed immediately prior to the start of the last control pulse (E).

2. A pulse shaper as claimed in Claim 1, characterised in that three field-effect transistors (T1, T2, T3) are of the self-blocking type and have identical channel doping and that the gate of the third field-effect transistor (T3) is directly or indirectly connected to the first supply potential ($V_{CC}$).

3. A pulse shaper as claimed in Claim 2, characterised in that the gate of the third field-effect transistor (T3) is directly connected to the first supply potential ($V_{CC}$).

4. A pulse shaper as claimed in Claim 1, characterised in that the gate of the third field-effect transistor (T3) is controlled by pre-load pulses (V) which occur in the pauses between the control pulses (E), and although the field-effect transistors (T1, T2, T3) in the second shaper component (F2) have identical channel doping, the third field-effect transistor (T3) is of the self-conductive type whereas the other transistors (T1, T2) are of the self-blocking type.

5. A pulse shaper as claimed in Claim 2, characterised in that the second shaper component (F2) has a fourth field-effect transistor (T4) and a fifth field-effect transistor (T5) of the same type as the other field-effect transistors (T1, T2, T3) and a second capacitor (C2), where the gate of the third field-effect transistor (T3) is connected *via* the mutually-parallel source-drain paths of the fourth and fifth field-effect transistors (T4, T5) to the first supply potential ($V_{cc}$) and is also connected to the gate of the fifth field-effect transistor (T5) and, *via* the second capacitor (C2), to that output of the pulse generator (JG) which supplies the control pulses (E), whereas the gate of the fourth field-effect transistor (T4) is connected to the first supply potential ($V_{cc}$).

6. A pulse shaper as claimed in one of Claims 1 to 5, characterised in that the first shaper component (F1) contains eleven field-effect transistors (t1-t11) of the type of the first transistor (T1) in the second shaper component (F2), together with a capacitor (C*), and is controlled by the pre-load pulses (V) in addition to the control pulses (E) supplied by the pulse generator (JG).

7. A pulse shaper as claimed in Claim 6, characterised in that the drain of a first field-effect transistor (t1) is connected to the first supply potential ($V_{cc}$) and its source forms the third signal output (3) of the first shaper component (F1) and is connected *via* a second field-effect transistor (t2) to the second supply potential ($V_{ss}$), that the gate of the first transistor (t1) is connected to the second signal output (2), to the gate of a third field-effect transistor (t3), and to the first terminal of a capacitor (C*) whose second terminal is connected to the source terminal of the third transistor (t3), whose drain is connected to the first supply potential ($V_{cc}$), and *via* a fourth transistor (t4) to the second supply potential ($V_{ss}$), that moreover the gates of the second transistor (t2) and of the fourth transistor (t4) are commonly connected to a circuit point between a seventh transistor (t7) and a ninth transistor (t9), where that transistor (t7) which is connected to the first supply potential ($V_{cc}$) is controlled by the pre-load pulses (V) and also has its source terminal connected *via* an eighth field-effect transistor (t8), which is controlled by the control pulses (E) of the pulse generator (JG), to the first signal output (1), to the gate of a fifth transistor (t5), and to the source of a sixth transistor (t6), that the source terminal of the fifth field-effect transistor (t5) is connected to the gate of the third field-effect transistor (t3) and its drain terminal is connected to that output of the pulse generator (JG) which supplies the control pulses (E), whereas the drain of the sixth transistor (t6) is connected to the terminal for the first supply potential ($V_{cc}$) and its gate is controlled by the pre-load pulses (V), that these pre-load pulses (V) also serve to control the gate of a tenth field-effect transistor (t10) whose source terminal is connected to the second supply potential ($V_{ss}$) and its drain to both the gate of the ninth transistor (t9) and to the first supply potential ($V_{cc}$) via the source-drain path of an eleventh field-effect transistor (t11) controlled by the control pulse (E), and that the ninth transistor (t9) is connected to the second supply potential ($V_{ss}$) in the same way as the second transistor (t2), the fourth transistor (t4) and the tenth transistor (t10).

8. A pulse shaper as claimed in one of Claims 1 to 7, characterised in that the signal output (A) of the second pulse shaper (F2) is connected to the gate of a sixth field-effect transistor (T6) of the same type as the first transistor (T1) in the second shaper component (F2), that the drain of the sixth transistor (T6) is connected to the first supply potential ($V_{cc}$) whereas its source terminal forms a first signal output (Q) of the second shaper component (F2) and is also connected via the source-drain path of a seventh field-effect transistor (T7) to the second supply potential ($V_{ss}$), and that the gate of the seventh field-effect transistor (T7) is controlled either by the aforementioned pre-load pulses (V) or by a follow-up circuit (NA) which consists of an eighth and a ninth field-effect transistor (T8, T9) controlled by the control pulse (E) and a further pulse (E*).

**Revendications**

1. Dispositif formeur d'impulsions, intégré, qui est réalisé selon la technique des circuits MIS, est raccordé à un premier potentiel d'alimentation ($V_{CC}$) ainsi qu'à un second potentiel d'alimentation ($V_{SS}$) servant de potentiel de référence, et est chargé avec des impulsions de commande (E) par un générateur d'impulsions (JG), caractérisé par le fait que les impulsions de commande (E) délivrées par le générateur d'impulsions (JG) servent aussi bien à charger directement une première partie (F1) du dispositif formeur d'impulsions, qu'une seconde partie (F2) du dispositif formeur d'impulsions commandée en supplément par l'intermédiaire de trois sorties de signaux (1, 2, 3) de la première partie (F1) du dispositif formeur d'impulsions et raccordée, contrairement à la première partie (F1) du dispositif formeur d'impulsions, uniquement au premier potentiel d'alimentation ($V_{CC}$), mais pas au second potentiel d'alimentation ($V_{SS}$) —, que la première sortie de signaux (1) de la première partie (F1) du dispositif formeur d'impulsions est prévue pour réaliser la commande de la grille d'un premier transistor à effet de champ (T1), dont la voie source-drain est reliée directement d'une part à la sortie, délivrant les impulsions de commande (E), du générateur d'impulsions (JG) et d'autre part à la sortie de signaux (A) délivrant les impulsions secondaires devant être produites et situées dans la seconde partie (F2) du dispositif formeur d'impulsions et qu'en outre la seconde sortie de signaux (2) de la première partie (F1) du dispositif formeur d'impulsions est prévue pour réaliser la commande de la grille d'un second transistor à effet de champ (T2), dont la voie source-drain est située entre la sortie de signaux (A) de la seconde partie (F2) du dispositif formeur d'impulsions et une borne d'un condensateur (C1) — raccordée par son autre borne à la troisième sortie de signaux (3) de la première partie (F1) du dispositif formeur d'impulsions —, que la borne du condensateur (C1), qui est reliée au second transistor à effet de champ (T2), est reliée par l'intermédiaire d'un troisième transistor à effet de champ (T3) au premier potentiel d'alimentation ($V_{CC}$), que la grille du troisième transistor à effet de champ (T3) est soit reliée au premier potentiel d'alimentation ($V_{CC}$), soit commandée au moyen d'impulsions de précharge (V) prévues pour la commande de la première partie (F1) du dispositif formeur d'impulsions, ces impulsions de précharge (V) apparaissant dans des pauses entre des impulsions de commande voisines (E),

— que la première partie (F1) du dispositif formeur d'impulsions contient un premier dispositif qui produit sur la première sortie de signaux (1) de la première partie (F1) du dispositif formeur d'impulsions, sous l'effet du flanc montant de chacune des impulsions de commande (E) délivrées par le générateur d'impulsions (JG), un premier signal (P1) dont la valeur de tension augmente simultanément, lors de la montée du flanc de l'impulsion de commande (E), depuis une valeur de tension située entre les deux potentiels d'alimentation ($V_{SS}$, $V_{CC}$) jusqu'à une valeur maximale qui est supérieure à la valeur du premier potentiel d'alimentation ($V_{CC}$) et retombe aussitôt après à la valeur du second potentiel d'alimentation ($V_{SS}$),

— que la première partie (F1) du dispositif formeur d'impulsions contient un second dispositif qui produit sur la seconde sortie de signaux (2) de la première partie (F1) du dispositif formeur d'impulsions, sous l'effet du flanc montant de chacune des impulsions de commande délivrées par le générateur d'impulsions (JG), un second signal (P2) dont la valeur de tension augmente, en même temps que la montée du flanc de l'impulsion de commande (E), depuis une valeur de tension égale au second potentiel d'alimentation ($V_{SS}$) jusqu'à la valeur du premier potentiel d'alimentation ($V_{CC}$) et, après avoir atteint la valeur du premier potentiel d'alimentation ($V_{CC}$), augmente, avec une vitesse de montée accrue par rapport à son accroissement jusqu'à la valeur du premier potentiel d'alimentation ($V_{CC}$), jusqu'à une valeur qui est supérieure à la valeur de ce premier potentiel d'alimentation ($V_{CC}$), et conserve cette valeur de tension, même après l'apparition du flanc retombant de l'impulsion de commande (E),

— que la première partie (F1) du dispositif formeur d'impulsions contient un troisième dispositif qui produit au niveau de la troisième sortie de signaux (3) de la première partie (F1) du dispositif formeur d'impulsions, sous l'effet du flanc montant de chacune des impulsions de commande (E) délivrées par le générateur d'impulsions (JG), un troisième signal (P3) dont la valeur de tension augmente à partir d'une valeur de tension égale au second potentiel d'alimentation ($V_{SS}$) et d'une façon retardée par rapport au flanc montant de l'impulsion de commande (E), jusqu'à la valeur du premier potentiel d'alimentation ($V_{CC}$) et conserve cette valeur même après l'apparition du flanc retombant de l'impulsion de commande (E),

— et qu'enfin il est prévu des moyens qui, après le passage du flanc retombant des impulsions de commande (E) délivrées par le générateur d'impulsions (JG) et avant l'apparition du flanc montant de l'impulsion de commande (E) immédiatement suivante, déclenchent un retour des signaux (P1, P2, P3), présents sur les trois sorties de signaux (1, 2, 3) de la première partie (F1) du dispositif formeur d'impulsions, dans l'état présent directement avant l'application de la première impulsion de commande (E).

2. Dispositif formeur d'impulsions suivant la revendication 1, caractérisé par le fait que les trois transistors à effet de champ (T1, T2, T3) sont du type auto-bloquants avec un même dopage de canal et que la grille du troisième transistor à effet de champ (T3) est reliée indirectement ou directement au premier potentiel d'alimentation ($V_{CC}$).

3. Dispositif formeur d'impulsions suivant la revendication 2, caractérisé par le fait que la grille du troisième transistor à effet de champ (T3) est raccordée directement au premier potentiel d'alimentation ($V_{CC}$).

4. Dispositif formeur d'impulsions suivant la revendication 1, caractérisé par le fait que, dans le cas d'une commande de la grille du troisième transistor à effet de champ (T3) par des impulsions de précharge (V) apparaissant pendant les pauses entre les impulsions de commande (P), les transistors à effet de champ (T1, T2, T3) situés dans la seconde partie (F2) du dispositif formeur d'impulsions possèdent assurément un dopage de canal identique, mais que le troisième transistor à effet de champ (T3) est du type auto-conducteur et que les autres transistors (T1, T2) sont du type auto-bloquants.

5. Dispositif formeur d'impulsions suivant la revendication 2, caractérisé par le fait qu'il est prévu un quatrième transistor à effet de champ (T4) et un cinquième transistor à effet de champ (T5), qui sont du type des autres transistors à effet de champ (T1, T2, T3), ainsi qu'un second condensateur (C2) dans la seconde partie (F2) du dispositif formeur d'impulsions et que la grille du troisième transistor à effet de champ (T3) est placée au premier potentiel d'alimentation ($V_{CC}$) par l'intermédiaire des voies source-drain, branchées réciproquement en parallèle, des quatrième et cinquième transistors à effet de champ (T4, T5) et est raccordée en outre à la grille du cinquième transistor à effet de champ (T5) ainsi que, par l'intermédiaire du second transistor (T2), à la sortie, délivrant les impulsions de commande (E), du générateur d'impulsions (JG), tandis que la grille du quatrième transistor à effet de champ (T4) est raccordée au premier potentiel d'alimentation ($V_{CC}$).

6. Dispositif formeur d'impulsions suivant l'une des revendications 1 à 5, caractérisé par le fait que la première partie (F1) du dispositif formeur d'impulsions contient onze transistors à effet de champ (t1-t11) du type du premier transistor (T1) situé dans la seconde partie (F2) du dispositif formeur d'impulsions et un condensateur (C*) et est commandée non seulement par les impulsions de commande (E) délivrées par le générateur d'impulsions (JG), mais également par les impulsions de précharge (V).

7. Dispositif formeur d'impulsions suivant la revendication 6, caractérisé par le fait qu'un premier transistor à effet de champ (t1) est placé, par son drain, au premier potentiel d'alimentation ($V_{CC}$) et forme, au moyen de sa source, la troisième sortie de signaux (3) de la première partie (F1) du dispositif formeur d'impulsions et est placé, par l'intermédiaire d'un second transistor à effet de champ (T2), au second potentiel d'alimentation ($V_{ss}$), que la grille du premier transistor (t1) est reliée d'une part à la seconde sortie de signaux (2) et d'autre part à la grille d'un troisième transistor à effet de champ (t3) ainsi qu'à une borne d'un convertisseur (C*), dont la seconde borne est raccordée à la borne de source du troisième transistor (t3) — placée par son drain au premier potentiel d'alimentation ($V_{cc}$) — ainsi que par l'intermédiaire d'un quatrième transistor (t4) au second potentiel d'alimentation ($V_{ss}$), qu'en outre les grilles du second transistor (t2) et du quatrième transistor (t4) sont raccordées en commun à un point du circuit situé entre un septième transistor (t7) et un neuvième transistor (t9), le transistor (t7) placé au premier potentiel d'alimentation ($V_{cc}$) étant commandé par les impulsions de précharge (V) et étant raccordé en outre par sa borne de source, par l'intermédiaire d'un huitième transistor à effet de champ (t8) — commandé par le générateur d'impulsions (JG) au moyen des impulsions de commande (E) — aussi bien à la première sortie de signaux (1) qu'à la grille d'un cinquième transistor (t5) et qu'à la source d'un sixième transistor (t6), que la borne de source du cinquième transistor à effet de champ (t5) est reliée à la grille du troisième transistor à effet de champ (t3) et que sa borne de drain est raccordée à la sortie, délivrant les impulsions de commande (E), du générateur d'impulsions (JG), tandis que le drain du sixième transistor (t6) est relié à la borne délivrant le premier potentiel d'alimentation ($V_{cc}$) et que sa porte est commandée par les impulsions de précharge (V), què ces impulsions de précharge (V) servent également à commander en outre la grille d'un dixième transistor à effet de champ (t10), dont la borne de source est placée au second potentiel d'alimentation ($V_{ss}$) et dont le drain est raccordé aussi bien à la grille du neuvième transistor (t9) ainsi que, par l'intermédiaire de la voie source-drain d'un onzième transistor à effet de champ (t11) commandée par l'impulsion de commande (E), au premier potentiel d'alimentation ($V_{cc}$), et que le neuvième transistor (T9) ainsi que le deuxième transistor (t2), le quatrième transistor (t4) et le dixième transistor (t10) sont raccordés au second potentiel d'alimentation ($V_{ss}$).

8. Dispositif formeur d'impulsions suivant l'une des revendications 1 à 7, caractérisé par le fait que la sortie de signaux (A) de la seconde partie (F2) du dispositif formeur d'impulsions est raccordée à la grille d'un sixième transistor à effet de champ (T6) du type du premier transistor (T1) situé dans la seconde partie (F2) du dispositif formeur d'impulsions, que le drain du sixième transistor (T6) est raccordé au premier potentiel d'alimentation ($V_{cc}$), tandis que sa borne de source forme d'une part une autre sortie de signaux (Q) de la seconde partie (F2) du dispositif formeur d'impulsions et est reliée en outre, par l'intermédiaire de la voie source-drain d'un septième transistor à effet de champ (T7), au second potentiel d'alimentation ($V_{ss}$), et que la grille du septième transistor à effet de champ (T7) est commandée soit par lesdites impulsions de précharge (V) soit par un circuit aval NA commandé par l'impulsion de commande (E) et par une autre impulsion (E*) et constitué par un huitième et un neuvième transistors à effet de champ (T8, T9).

0 095 060

FIG 1

FIG 2

FIG 3

a)

a')

b)

c)

d)

e)

FIG 4

1

# FIG 5

FIG 6